# EUROPEAN PATENT APPLICATION

(11) **EP 4 585 948 A1**
(43) Date of publication of application: **16.07.2025**
(21) Application number: 23947393.7
(22) Date of filing: 07.12.2023
(51) Int. Cl.: G01R 31/385, G01R 31/378

(54) **SELF-DISCHARGE SCREENING METHOD AND APPARATUS FOR LITHIUM-ION BATTERY**

(30) Priority: 31.07.2023 CN 202310964643
(71) Applicant: Eve Power Co., Ltd., Jingmen, Hubei 448000 (CN)
(72) Inventor: LI, Xia, Jingmen, Hubei 448000 (CN); GAO, Zhiyong, Jingmen, Hubei 448000 (CN); SU, Bin, Jingmen, Hubei 448000 (CN); CHEN, Liquan, Jingmen, Hubei 448000 (CN)
(74) Representative: Herrero & Asociados, S.L.
(86) International application number: PCT/CN2023/137288
(87) International publication number: WO 2025/025456

(57) **Abstract**

A self-discharge screening method and a self-discharge screeningapparatus for lithium-ion batteries. High-temperature standing, first room-temperature standing, and second room-temperature standing are performed on batteries to be tested. Screenings are performed on the batteries to be tested according to process parameters of the first standing and the previous two periods of standing. Physical self discharge rates of the remaining batteries to be tested are determined according to the process parameters of the three periods of standing, and physical self-discharge screening is performed. The physical self-discharge rates of the batteries to be tested are determined by using the state parameters, and batteries with non-obvious type physical self-discharge abnormalities are screened out.

## Description

The present disclosure claims priority to Chinese Patent Application No. 202310964643.7, filed with the Chinese Patent Office on July 31, 2023, the disclosure of which is incorporated herein by reference in its entirety.

### TECHNICAL FIELD

Embodiments of the present disclosure relate to energy storage battery technologies, and in particular, to a self-discharge screening method and a self-discharge screening apparatus for lithium-ion batteries.

### BACKGROUND

Self-discharge phenomenon is an inherent characteristic of lithium-ion batteries, which manifests as a continuous decrease in the capacity of the lithium-ion batteries over time when they are in a static state. Affected by factors such as raw material batches, manufacturing processes, manufacturing environments and management levels, there are differences in self-discharge rates of lithium batteries produced in scale-up batches. For client application scenarios, it is necessary to ensure the consistency in the self-discharge rate of batteries in a integrated battery pack.

In the related technologies, a commonly used method for self-discharge screening is a K value method (also known as a self-discharge rate screening method), the principle of which is to calculate the self-discharge rates of batteries according to a difference between open-circuit voltages of the batteries before and after a standing duration and the standing duration, and then screen out batteries with overstandard self-discharge according to the self-discharge rates.

However, when the K value method is used for self-discharge screening, the accuracy of the screening is limited by the standing duration, resulting in poor accuracy of battery screening in the self-discharge screening within a limited time.

### TECHNICAL PROBLEM

The present disclosure provides a self-discharge screening method and a self-discharge screening apparatus for lithium-ion batteries, to improve the accuracy of self-discharge screening on the basis of limited standing duration.

### TECHNICAL SOLUTION

According to a first aspect, the embodiments of the present disclosure provide a self-discharge screening method for lithium-ion batteries. The self-discharge screening method for lithium-ion batteries includes:
adjusting batteries to be tested in a batch to be tested to a preset state of charge respectively;
performing high-temperature standing on the batteries to be tested that are at the preset state of charge;
performing, according to state parameters of the batteries to be tested during the high-temperature standing, high-temperature screening on the batteries to be tested in the batch to be tested;
performing first room-temperature standing on remaining batteries to be tested in the batch to be tested after the high-temperature screening;
performing, according to state parameters of the batteries to be tested during the high-temperature standing and the first room-temperature standing, room-temperature screening on the remaining batteries to be tested in the batch to be tested;
performing second room-temperature standing on remaining batteries to be tested in the batch to be tested after the room-temperature screening;
determining physical self-discharge rates of the batteries to be tested according to state parameters of the batteries to be tested in the high-temperature standing, the first room-temperature standing and the second room-temperature standing;
performing, according to the physical self-discharge rates of the batteries to be tested, physical self-discharge screening on the remaining batteries to be tested in the batch to be tested after the room-temperature screening.

According to a second aspect, the embodiments of the present disclosure further provides a self-discharge screening apparatus for lithium-ion batteries. The self-discharge screening apparatus for lithium-ion batteries includes a charge state adjusting module, a high-temperature standing module, a high-temperature screening module, a first room-temperature standing module, a room-temperature screening module, a second room-temperature standing module, a physical self-discharge determination module, and a physical screening module;
the charge state adjusting module is configured to respectively adjust batteries to be tested in a batch to be tested to a preset state of charge;
the high-temperature standing module is configured to perform high-temperature standing on the batteries to be tested;
the high-temperature screening module is configured to perform high-temperature screening on the batteries to be tested in the batch to be tested according to state parameters of the batteries to be tested during the high-temperature standing;
the first room-temperature standing module is configured to perform first room-temperature standing on remaining batteries to be tested in the batch to be tested after the high-temperature screening;
the room-temperature screening module is configured to perform, according to state parameters of the batteries to be tested during the high-temperature standing and the first room-temperature standing, room-temperature screening on the remaining batteries to be tested in the batch to be tested;
the second room-temperature standing module is configured to perform second room-temperature standing on remaining batteries to be tested in the batch to be tested after the room-temperature screening;
the physical self-discharge determination module is configured to determine physical self-discharge rates of the batteries to be tested according to state parameters of the batteries to be tested during the high-temperature standing, the first room-temperature standing and the second room-temperature standing;
the physical screening module is configured to perform, according to the physical self-discharge rates of the batteries to be tested, physical self-discharge screening on the remaining batteries to be tested in the batch to be tested after the room-temperature screening.

### BENEFICIAL EFFECTS

Beneficial effects of the present disclosure: in the self-discharge screening method and apparatus for lithium-ion batteries provided by the embodiments of the present disclosure, the high-temperature standing, the first room-temperature standing, and the second room-temperature standing are successively performed on the plurality of batteries to be tested in the batch to be tested. After the previous two periods of standing, the batteries to be tested in the batch to be tested are screened respectively according to the obtained process parameters of the first standing and the previous two periods of standing. After the last standing, the physical self-discharge rates of the remaining batteries to be tested are determined according to the process parameters of the three standing processes, and physical self-discharge screening is performed on the remaining batteries to be tested according to the physical self-discharge rates, thereby realizing the self-discharge screening of the lithium-ion batteries. After standing and screening twice, the physical self-discharge rate of the battery to be tested is determined using the state parameters, and then the batteries with non-obvious type physical self-discharge abnormalities are screened out, thereby improving the accuracy of self-discharge screening on the basis of limited standing time.

### BRIEF DESCRIPTION OF THE DRAWINGS

FIG. 1 is a diagram showing voltage variation curves of lithium iron phosphate batteries at a 20% state of charge as a function of standing time;
FIG. 2 is a diagram showing variation curves of voltage drops caused by different types of self-discharge in a battery with abnormal physical self-discharge;
FIG. 3 is a schematic flowchart of a self-discharge screening method for lithium-ion batteries provided by embodiments of the present disclosure;
FIG. 4 is a schematic flowchart of another self-discharge screening method for lithium-ion batteries provided by embodiments of the present disclosure;
FIG. 5 is a schematic structural diagram of a self-discharge screening apparatus for lithium-ion batteries provided by embodiments of the present disclosure.

### DETAILED DESCRIPTION

As described in the background, a commonly used method for self-discharge screening in industry is a K value method, the principle of which is to calculate the self-discharge rates of batteries according to a difference between open-circuit voltages of the batteries before and after a standing duration and the standing duration, and then screen out batteries with overstandard self-discharge according to the self-discharge rates. However, the accuracy of self-discharge screening using the K value method is limited by the standing duration, resulting in poor screening accuracy for the self-discharge screening within a limited time before leaving the factory. Since lithium-ion batteries are widely used in new energy vehicles and are close to people's lives, users generally pay high attention to the safety of lithium-ion batteries. In order to ensure the user's trust and ensure that safety does not restrict the development of the lithium-ion batteries, an outflow rate of the lithium-ion batteries with self-discharge abnormalities needs to be controlled at a ppb level (also known as within one billionth). However, based on reported data of the self-ignition event of new energy vehicles on the current market, the inventors have calculated that the self-discharge screening method of related technologies has resulted in the outflow rate of lithium-ion batteries with self-discharge abnormalities only reaching a ppm level (also known as within one millionth). Therefore, an innovation of the self-discharge screening method is crucial to an improvement of the safety of lithium-ion batteries and an improvement of the customer quality perception.

The inventors have found that self-discharge failures are divided into two types: chemical self-discharge failure and physical self-discharge failure. Common failure causes of the chemical self-discharge are generally due to excessive moisture in the electrolyte or electrode, which affects chemical reactions. While common failure causes of the physical self-discharge are generally due to physical reasons such as excessive magnetic substances and dust short circuits.

The voltage drop caused by chemical self-discharge can be expressed by a chemical self-discharge formula: V_{chem}=A(-Ea/RT)t^{z}, where A is a pre-exponential factor, which is a coefficient term; Ea is chemical self-discharge activation energy of a battery to be tested, which relates to a state of charge of the battery to be tested during screening and a formation condition of an SEI film, and its unit is J/mol; R is an ideal gas state constant, which can be taken as 8.314J/(mol/K); T is a standing temperature in K; t is a standing duration in days; z is an exponential power of the standing duration, which may be taken as a fixed coefficient. After analyzing the above causes of chemical self-discharge failure in combination with the chemical self-discharge formula, the inventors considered that the accuracy of chemical self-discharge screening can be improved by increasing the standing temperature.

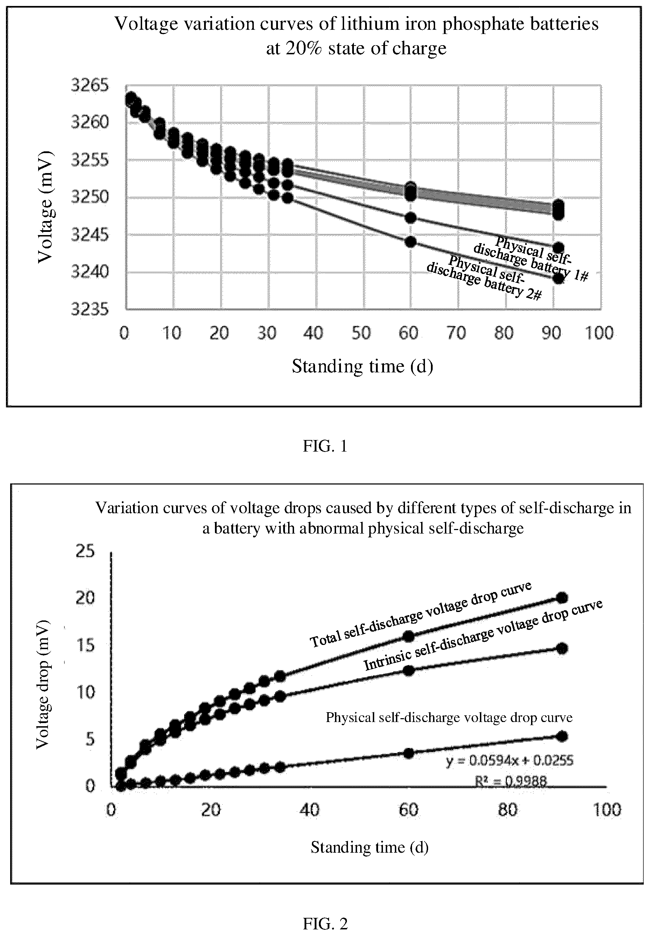

The voltage drop caused by physical self-discharge can be expressed by a physical self-discharge formula: V_{phys}=kt, where k is a physical self-discharge rate in mV/d; t is a standing time in days. Batteries that experience physical self-discharge failure in the later stage generally exhibit three types of manifestations during the initial standing periods: obvious type, general type and non-obvious type. The non-obvious type physical self-discharge has a very strong hiding ability, and the value of the physical self-discharge rate is small. It usually takes more than 1 month or even 2 to 3 months of long-term standing to distinguish it from the entire batch of batteries, while the obvious type and the general type do not take that long. FIG. 1 is a diagram showing voltage variation curves of lithium iron phosphate batteries at 20% state of charge as a function of standing time. Referring to FIG. 1, it can be seen from experimental data of the inventors that, when the storage duration is 30 days, the voltages of two batteries (physical self-discharge battery 1# and physical self-discharge battery 2#) with poor physical self-discharge start to show differences from other batteries. When the standing duration is 60 to 90 days, their voltages have obvious differences from other normal batteries. When using conventional long-term static voltage drop testing screening techniques, these two physical self-discharge batteries need to be left to stand for more than 60 days to be screened out. If a battery with a similar non-obvious type physical self-discharge abnormalities appears in a batch to be screened, long-term static storage is unrealistic for large-scale production of enterprises. Batteries with non-obvious type physical self-discharge abnormalities are likely to flow into the client, causing quality and safety problems.

In order to solve the described problems, the inventors conducted further researches and, based on daily screening data, researched and disassembled a large number of faulty batteries with physical self-discharge abnormalities. FIG. 2 is a diagram showing variation curves of voltage drops caused by different types of self-discharge in a battery with abnormal physical self-discharge. Combining FIG. 1 and FIG. 2, the inventors have decomposed the voltage drops caused by different types of self-discharge in the physical self-discharge battery 1# in FIG. 1 as an example. It can be seen from experimental data that, in the battery with poor physical self-discharge, the total self-discharge voltage drop = intrinsic self-discharge voltage drop + physical self-discharge voltage drop, wherein the intrinsic self-discharge voltage drop is a self-discharge voltage drop that a normal lithium-ion battery would produce during a standing state, which is actually a voltage drop caused by chemical self-discharge. The physical self-discharge voltage drop is linearly related to the standing time of the battery, that is, the physical self-discharge rate is constant.

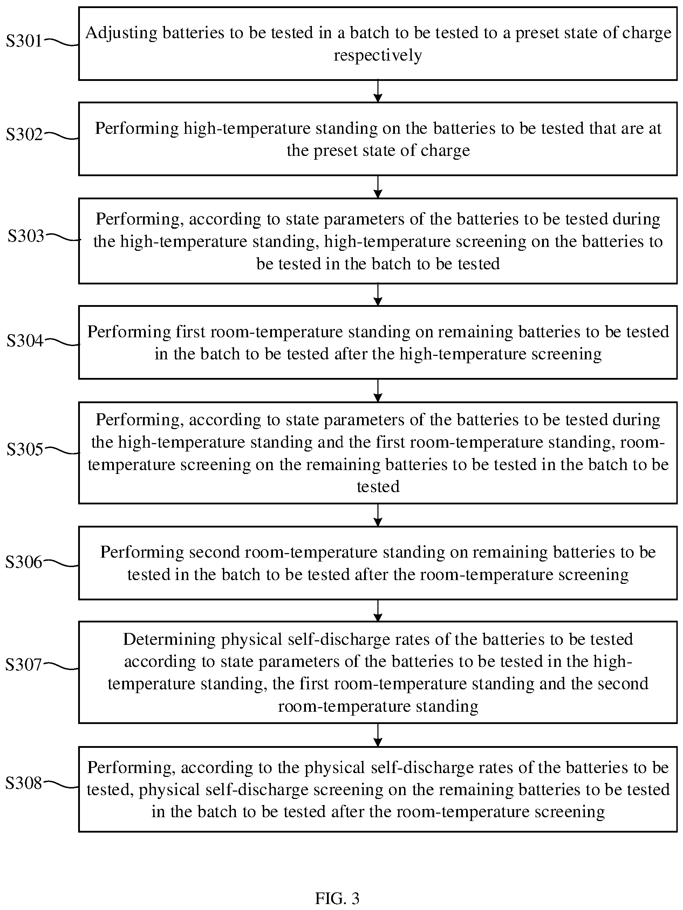

Based on this, the embodiments of the present disclosure provide a self-discharge screening method for lithium-ion batteries. The screening method is applied to screening of a batch of batteries to be tested. FIG. 3 is a schematic flowchart of a self-discharge screening method for lithium-ion batteries provided by embodiments of the present disclosure. Referring to FIG. 3, the self-discharge screening method for lithium-ion batteries includes:
S301, adjusting batteries to be tested in a batch to be tested to a preset state of charge respectively.

Specifically, there are a plurality of batteries to be tested in the batch to be tested. For example, the batch to be tested may include more than one hundred batteries to be tested. Each battery to be tested within the batch has the same battery system, similar production time, the same batch of materials and the same capacity. The preset state of charge refers to a set value of a state of charge to which the batteries to be tested need to be uniformly adjusted before self-discharge screening. A value of the preset state of charge is related to the battery system of the batteries to be tested in the batch to be tested. For example, if the battery system of the batteries to be tested is lithium iron phosphate (also called LFP), then the preset state of charge can take any value in a range of 10% to 20%. The states of charge of the batteries to be tested in the batch to be tested are all adjusted to the preset states of charge by means of charging and discharging.

S302, performing high-temperature standing on the batteries to be tested that are at the preset state of charge.

Specifically, standing processes in the self-discharge screening method for lithium-ion batteries include high-temperature standing, first room-temperature standing, and second room-temperature standing. The high-temperature standing refers to an operation of placing the batteries to be tested at a temperature condition higher than room temperature for standing. For example, the temperature condition of the high-temperature standing may be any value in a range of 40°C to 50°C, and a standing duration may be any value in a range of 2 to 3 days. The batteries to be tested that are at the preset state of charge are placed at the same preset high temperature for standing operation, so that the chemical self-discharge rate is significantly increased compared with that at room temperature, which is convenient for subsequent screening.

S303, performing, according to state parameters of the batteries to be tested during the high-temperature standing, high-temperature screening on the batteries to be tested in the batch to be tested.

Specifically, the state parameters refer to parameters that can reflect a self-discharge status of the battery to be tested. For example, the state parameters during the high-temperature standing may include a first standing duration, first open-circuit voltages of the batteries to be tested before the high-temperature standing, and second open-circuit voltages of the batteries to be tested after the high-temperature standing. According to the state parameters of the battery to be tested in the high-temperature standing, the self-discharge rate of the battery to be tested in the high-temperature standing can be determined. Then, high-temperature screening can be performed on all the batteries to be tested in the batch to be tested according to the self-discharge rates of the plurality of batteries to be tested in the high-temperature standing, so as to screen out the batteries to be tested of which the self-discharge degree exceeds a standard during the present high-temperature standing. The batteries to be tested that are screened out in this high-temperature screening step include batteries with chemical self-discharge abnormalities and batteries with obvious type physical self-discharge abnormalities.

For example, according to a voltage difference of the battery to be tested before and after the high-temperature standing and a standing duration of the high-temperature standing, a first unit voltage drop generated by the battery to be tested per unit standing time during the high-temperature standing can be calculated. Then, the first unit voltage drop of the battery to be tested is compared with a first preset voltage drop, and the battery to be tested of which the first unit voltage drop is greater than the first preset voltage drop is determined as a battery with abnormal self-discharge and is screened out.

S304, performing first room-temperature standing on remaining batteries to be tested in the batch to be tested after the high-temperature screening.

Specifically, the first room-temperature standing refers to an operation of placing the batteries to be tested at a room temperature conditions for standing. For example, the temperature condition of the first room-temperature standing may be any value in a range of 20°C to 30°C, and a standing duration may be any value in a range of 2 to 4 days. The remaining batteries to be tested after the high-temperature screening in step S303 are placed at the same preset room temperature for a standing operation.

S305, performing, according to state parameters of the batteries to be tested during the high-temperature standing and the first room-temperature standing, room-temperature screening on the remaining batteries to be tested in the batch to be tested.

Specifically, the state parameters refer to parameters that can reflect a self-discharge status of the battery to be tested. For example, the state parameters during the high-temperature standing may include the first standing duration, the first open-circuit voltages of the batteries to be tested before the high-temperature standing, and the second open-circuit voltages of the batteries to be tested after the high-temperature standing. The state parameters during the first room-temperature standing may include a second standing duration and third open-circuit voltages of the batteries to be tested after the first room-temperature standing. A total self-discharge rate of the battery to be tested during the high-temperature standing and the first room-temperature standing can be determined according to the state parameters of the battery to be tested during the high-temperature standing and the first room-temperature standing. According to the total self-discharge rates of the plurality of batteries to be tested during the high-temperature standing and the first room-temperature standing, the first room-temperature screening is performed on all the remaining batteries to be tested in the batch to be tested, to screened out the batteries to be tested of which the total self-discharge degree exceeds a standard during the high-temperature standing and the first room-temperature standing. The batteries to be tested that are screened out in this room-temperature screening step include batteries with general type physical self-discharge abnormalities.

For example, according to the voltage difference of the battery to be tested before the high-temperature standing and after the first room-temperature standing, as well as a total standing duration of the high-temperature standing and the first room-temperature standing, a second unit voltage drop generated by the battery to be tested per unit time during the high-temperature standing and the first room-temperature standing can be calculated. Then, the second unit voltage drop of the battery to be tested is compared with a second preset voltage drop, and the battery to be tested of which the second unit voltage drop is greater than the first preset voltage drop is determined as a battery with abnormal self-discharge and is screened out.

S306, performing second room-temperature standing on remaining batteries to be tested in the batch to be tested after the room-temperature screening.

Specifically, the second room-temperature standing refers to an operation of placing the batteries to be tested at a room temperature condition for standing, which is different from the first room-temperature standing in terms of standing duration and sequence. For example, the temperature condition of the second room-temperature standing may be the same as that of the first room-temperature standing, and may be any value in a range of 20°C to 30°C, and the standing duration may be any value in a range of 3 to 5 days. The remaining batteries to be tested after the first room-temperature screening in step S305 are placed at the same preset room temperature for a standing operation.

S307, determining physical self-discharge rates of the batteries to be tested according to state parameters of the batteries to be tested in the high-temperature standing, the first room-temperature standing and the second room-temperature standing.

Specifically, the previous two screenings can screen out the batteries to be tested with chemical self-discharge abnormalities, obvious type physical self-discharge abnormalities, and general type physical self-discharge abnormalities. However, a few days of standing duration still is not enough to screen out the batteries to be tested with non-obvious type physical self-discharge abnormalities through traditional methods such as voltage drop or unit voltage drop. In this step, according to the state parameters of the remaining batteries to be tested in the batch to be tested during the high-temperature standing, the first room-temperature standing, and the second room-temperature standing, a normal value of the self-discharge voltage drop that a normal battery would generate during each standing process, that is, an intrinsic voltage drop, can be determined respectively. For example, the state parameters of the second room-temperature standing include a third standing duration and a fourth open-circuit voltage of the battery to be tested after the second room-temperature standing. According to deviations between a plurality of batteries to be tested and the intrinsic voltage drop, physical self-discharge voltage drops of the batteries to be tested in multiple standing processes can be determined. The physical self-discharge rate of the battery to be tested can be determined by combining the standing durations of multiple standing processes with their physical self-discharge voltage drop.

S308, performing, according to the physical self-discharge rates of the batteries to be tested, physical self-discharge screening on the remaining batteries to be tested in the batch to be tested after the room-temperature screening.

Specifically, according to the physical self-discharge rates of the remaining batteries to be tested in the batch to be tested, it can be determined whether the physical self-discharge rates of the batteries to be tested are normal, and then the remaining batteries to be tested in the batch to be tested are subjected to physical self-discharge screening. For example, the method for determining whether the physical self-discharge rate of the battery to be tested are normal is, on the one hand, to compare the physical self-discharge rate with a preset rate, and on the other hand, to use the physical self-discharge rate of the battery to be tested to predict a voltage drop caused by physical self-discharge of the battery to be tested when the battery to be tested is used for the first time, and then compare the voltage drop with a preset voltage drop threshold, which is not limited herein. In this step, by using the physical self-discharge rate of the battery to be tested, a battery to be tested with non-obvious type physical self-discharge abnormality can be screened out.

In the self-discharge screening method for lithium-ion batteries provided by the embodiments, the high-temperature standing, the first room-temperature standing, and the second room-temperature standing are successively performed on the plurality of batteries to be tested in the batch to be tested. After the previous two periods of standing, the batteries to be tested in the batch to be tested are screened respectively according to the obtained process parameters of the first standing and the previous two periods of standing. After the last standing, the physical self-discharge rates of the remaining batteries to be tested are determined according to the process parameters of the three standing processes, and physical self-discharge screening is performed on the remaining batteries to be tested according to the physical self-discharge rates, thereby realizing the self-discharge screening of the lithium-ion batteries. After standing and screening twice, the physical self-discharge rate of the battery to be tested is determined using the state parameters, and then the batteries with non-obvious type physical self-discharge abnormalities are screened out, thereby improving the accuracy of self-discharge screening on the basis of limited standing time.

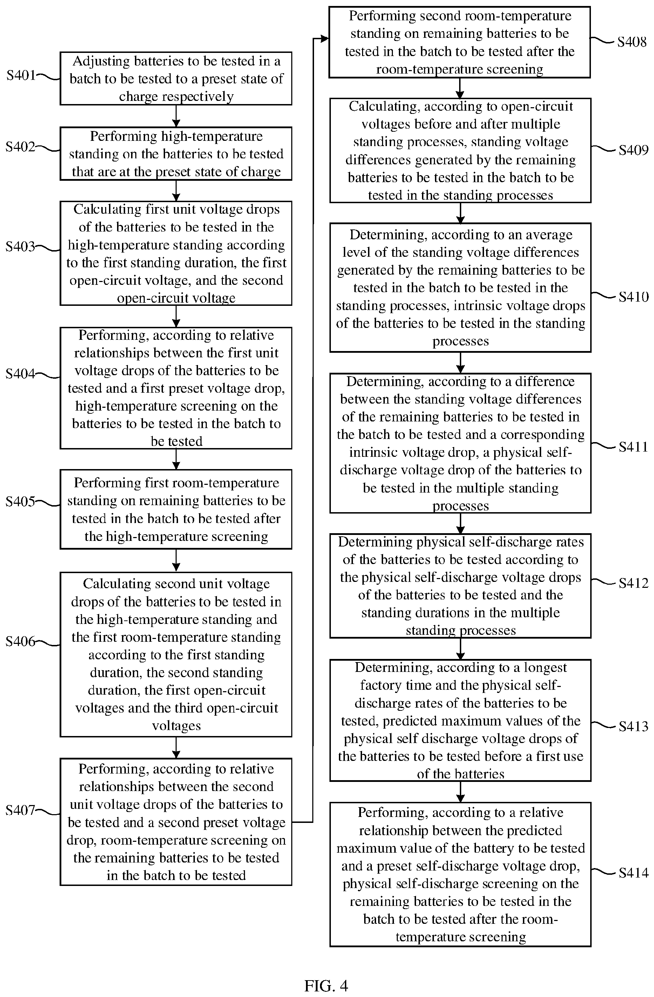

FIG. 4 is a schematic flowchart of another self-discharge screening method for lithium-ion batteries provided by the embodiments of the present disclosure. Referring to FIG. 4, based on the foregoing embodiments, the self-discharge screening method for lithium-ion batteries includes:
S401, adjusting batteries to be tested in a batch to be tested to a preset state of charge respectively.
S402, performing high-temperature standing on the batteries to be tested that are at the preset state of charge.
Steps S401 and S402 correspond one-to-one with steps S301 and S302, and have the same contents, which will not be repeated here.
S403, calculating first unit voltage drops of the batteries to be tested in the high-temperature standing according to the first standing duration, the first open-circuit voltage, and the second open-circuit voltage.

Specifically, the first unit voltage drop refers to a voltage drop generated by the battery to be tested per unit time on average during the high-temperature standing. By combining the first standing duration, the first open-circuit voltage, and the second open-circuit voltage with a first calculation formula, the first unit voltage drop of the battery to be tested during the high-temperature standing can be calculated. The first calculation formula is K₁ = (OCV1-OCV2)/Δt₁, where K₁ is a first unit voltage drop (also referred to as a first self-discharge rate) of the battery to be tested during the high-temperature standing; OCV1 is first open-circuit voltages of the batteries to be tested before the high-temperature standing; OCV2 is second open-circuit voltages of the batteries to be tested after the high-temperature standing; and Δt₁ is a first standing duration of the high-temperature standing, which is a time difference between collecting the second open-circuit voltage and collecting the first open-circuit voltage.

S404, performing, according to relative relationships between the first unit voltage drops of the batteries to be tested and a first preset voltage drop, high-temperature screening on the batteries to be tested in the batch to be tested.

Specifically, the first preset voltage drop is a voltage drop threshold for high-temperature screening, which is related to a lithium battery material system of the batteries to be tested, a preset state of charge value, and the first standing duration of the high-temperature standing. For example, the first preset voltage drop may be determined according to long-term storage data of the batteries to be tested and disassembly data of the batteries with chemical self-discharge abnormalities. Determine whether the first unit voltage drops of a plurality of batteries to be tested are greater than or equal to the first preset voltage drop. If the first unit voltage drop of the battery to be tested is greater than or equal to the first preset voltage drop, it indicates that a voltage drop of the battery to be tested during the high-temperature standing exceeds a normal range, and the battery can be determined to be a battery with abnormal self-discharge and is screened out. If the first unit voltage drop of the battery to be tested is less than the first preset voltage drop, it indicates that the voltage drop of the battery to be tested during the high-temperature standing is within the normal range, and the battery can be determined to be a normal battery and is retained. According to such a high-temperature screening manner, the batteries with chemical self-discharge abnormalities and the batteries with obvious type physical self-discharge abnormalities in the batteries to be tested in batch to be tested can be screened out.

S405, performing first room-temperature standing on remaining batteries to be tested in the batch to be tested after the high-temperature screening.

Step S405 corresponds to step S305, and has the same contents, which will not be repeated here.

S406, calculating second unit voltage drops of the batteries to be tested in the high-temperature standing and the first room-temperature standing according to the first standing duration, a second standing duration, the first open-circuit voltages and a third open-circuit voltages.

Specifically, the second unit voltage drop refers to a voltage drop generated by the battery to be tested per unit time on average during a total process of the high-temperature standing and the first room-temperature standing. By combining the first standing duration, the second standing duration, the first open-circuit voltage, and the third open-circuit voltage with a second calculation formula, the second unit voltage drop of the battery to be tested during the high-temperature standing and the first room-temperature standing can be calculated. The second calculation formula is K₂ = (OCV1-OCV3)/(Δt₁+Δt₂), where K₂ is a second unit voltage drop (also referred to as a second self-discharge rate) of the battery to be tested during the high-temperature standing and the first room-temperature standing; OCV1 is a first open-circuit voltage of the battery to be tested before the high-temperature standing; OCV3 is a third open-circuit voltage of the battery to be tested after the first room-temperature standing; Δt₂ is a second standing duration of the first room-temperature standing, which is a time difference between an end and a start of the first room-temperature standing.

S407, performing, according to relative relationships between the second unit voltage drops of the batteries to be tested and a second preset voltage drop, room-temperature screening on the remaining batteries to be tested in the batch to be tested.

Specifically, the second preset voltage drop is a voltage drop threshold for room temperature screening, which is related to a lithium battery material system of the battery to be tested, a preset state of charge value, the first standing duration of the high-temperature standing, and the second standing duration of the first room-temperature standing. For example, the second preset voltage drop may be determined according to long-term storage data of the batteries to be tested and disassembly data of the batteries with general type physical self-discharge abnormalities. Determine whether the second unit voltage drops of the plurality of remaining batteries to be tested in the batch to be tested are greater than or equal to the second preset voltage drop. If the second unit voltage drop of the battery to be tested is greater than or equal to the second preset voltage drop, it indicates that a voltage drop of the battery to be tested during the total process of the high-temperature standing and the first room-temperature standing exceeds a normal range, and the battery can be determined to be a battery with abnormal self-discharge and is screened out. If the second unit voltage drop of the battery to be tested is less than the second preset voltage drop, it indicates that the voltage drop of the battery to be tested during the total process of the high-temperature standing and the first room-temperature standing is within the normal range, and the battery can be determined to be a normal battery and is retained. According to such a room-temperature screening manner, the batteries with general type physical self-discharge abnormalities in the batteries to be tested in the batch to be tested can be screened out.

S408, performing second room-temperature standing on remaining batteries to be tested in the batch to be tested after the room-temperature screening.

Step S408 corresponds to step S306, and has the same contents, which will not be repeated here.

S409, calculating, according to open-circuit voltages before and after multiple standing processes, standing voltage differences generated by the remaining batteries to be tested in the batch to be tested in the standing processes.

Specifically, the standing processes include a first process, a second process and a third process, where the first process includes the high-temperature standing; the second process includes the high-temperature standing and the first room-temperature standing; and the third process includes the high-temperature standing, the first room-temperature standing and the second room-temperature standing. The open-circuit voltages before and after the first process are respectively the first open-circuit voltage and the second open-circuit voltage. The open-circuit voltages before and after the second process are respectively the first open-circuit voltage and the third open-circuit voltage. The open-circuit voltages before and after the third process are respectively the first open-circuit voltage and the fourth open-circuit voltage. According to a difference in open-circuit voltages before and after the standing processes, the standing voltage differences generated by the remaining battery to be tested in the batch to be tested in the standing processes can be calculated. For example, calculation formulas for the standing voltage difference in the standing processes are: ΔV1=OCV1-OCV2, ΔV2=OCV1-OCV3 and ΔV3=OCV1-OCV4, where ΔV1 is the standing voltage difference generated in the first process and is recorded as a first voltage difference; ΔV2 is the standing voltage difference generated in the second process and is recorded as a second voltage difference; and ΔV3 is the standing voltage difference generated in the third process and is recorded as a third voltage difference.

S410, determining, according to an average level of the standing voltage differences generated by the remaining batteries to be tested in the batch to be tested in the standing processes, intrinsic voltage drops of the batteries to be tested in the standing processes.

Specifically, according to the standing voltage differences generated by the plurality of remaining batteries to be tested in the batch to be tested in the standing process, the average level of the standing voltage differences in the standing process can be determined. For example, the average level can be represented by an arithmetic mean or a median value. In a standing process, if the average level of the standing voltage differences of the plurality of remaining batteries to be tested is X, then the intrinsic voltage drop of the batteries to be tested in the standing process is X. The intrinsic voltage drop may represent a self-discharge voltage drop generated by a battery to be tested with normal self-discharge due to own chemical properties of the battery itself during a standing process. This part of the self-discharge voltage drop conforms to the chemical self-discharge formula and belongs to chemical self-discharge generation. The difference between the intrinsic voltage drop and the voltage drop caused by abnormal chemical self-discharge is that the greater the activation energy of the chemical self-discharge of the battery to be tested is, the greater the intrinsic voltage drop is, while there is no such relationship between the voltage drop caused by the abnormal chemical self-discharge and the activation energy of the chemical self-discharge.

For example, the average level is represented by a median value. The median value may represent an actual self-discharge voltage drop level of a normal battery to be tested, and is not affected by an abnormal value, so it is very suitable for representing the intrinsic voltage drop during the standing process. The standing voltage differences generated by the plurality of remaining batteries to be tested in the batch to be tested in the standing processes are ranked in order of the values of the standing voltage differences. According to the ranking of the standing voltage differences, a median value of the standing voltage differences may be determined as the intrinsic voltage drop of the battery to be tested in the standing processes.

S411, determining, according to a difference between the standing voltage differences of the remaining batteries to be tested in the batch to be tested and a corresponding intrinsic voltage drop, a physical self-discharge voltage drop of the batteries to be tested in the multiple standing processes.

Specifically, in the above-mentioned high-temperature screening, batteries with chemical self-discharge abnormalities have been screened out, so it may be determined that the remaining batteries to be tested are batteries with normal chemical self-discharge, so the voltage drops caused by these batteries to be tested due to chemical self-discharge in a standing process is the intrinsic voltage drop. The difference value between the standing voltage difference of the remaining battery to be tested in the batch to be tested and the corresponding intrinsic voltage drop may represent a voltage difference value caused by the battery to be tested due to physical self-discharge, that is, the physical self-discharge voltage drop of the battery to be tested in the standing process. In this way, the physical self-discharge voltage drops of the remaining battery to be tested in the batch to be tested in the three different standing processes can be determined.

S412, determining physical self-discharge rates of the batteries to be tested according to the physical self-discharge voltage drops of the batteries to be tested and the standing durations in the multiple standing processes.

Specifically, the standing duration refers to a duration of the standing process, which may be determined according to the sum of the standing times of multiple standing steps included in the standing process. For example, the standing duration of the first process is equal to the first standing duration. The standing duration of the second process is equal to the sum of the first standing duration and the second standing duration. The standing duration of the third process is equal to the sum of the first standing duration, the second standing duration and the third standing duration. According to the standing duration and the physical self-discharge voltage drop corresponding to the standing process, the physical self-discharge voltage drop of the battery to be tested per unit time in the standing process can be determined. According to the physical self-discharge voltage drop per unit time corresponding to different standing processes of the battery to be tested, a final physical self-discharge voltage drop of the battery to be tested may be determined as a physical self-discharge rate of the battery to be tested.

For example, according to the physical self-discharge voltage drops of the batteries to be tested in the multiple standing processes and the standing durations, a relationship curve of the physical self-discharge voltage drops of the batteries to be tested and the standing durations can be fitted, and the relationship curve can be expressed by a third equation. The third equation is y=kx+c, where y is the physical self-discharge voltage drop during the standing process, x is the standing duration during the standing process, k is a slope of the relationship curve, and c is a constant. The physical self-discharge rate of the batteries to be tested is determined according to the slope of the relationship curve.

S413, determining, according to a longest factory time and the physical self-discharge rates of the batteries to be tested, predicted maximum values of the physical self discharge voltage drops of the batteries to be tested before a first use of the batteries.

Specifically, the longest factory time refers to a longest storage time that the battery to be tested can reach from a completion of production on a production line to the time it is put into use by users according to regulations. The longest factory time is preset by manufacturers based on experimental data or experimental data to ensure that the self-discharge voltage drop caused during storage does not affect the normal use of the users. The product of the longest factory time of the battery to be tested and the physical self-discharge rate are calculated, which is the predicted maximum value of the physical self-discharge voltage drop before the first use of the battery to be tested.

In S414, performing, according to a relative relationship between the predicted maximum value of the battery to be tested and a preset self-discharge voltage drop, physical self-discharge screening on the remaining batteries to be tested in the batch to be tested after the room-temperature screening.

Specifically, the preset self-discharge voltage drop refers to a screening threshold of a physical self-discharge voltage drop in the physical self-discharge screening, which may be determined according to a standard value of the voltage difference before the battery to be tested is assembled. The standard value of the voltage difference refers to a maximum voltage difference allowed between batteries in a group when the batteries to be tested are assembled into a battery pack. For example, the standard value of the voltage difference may be 5 mV, and a corresponding preset self-discharge voltage drop may be equal to the standard value 5 mV of the voltage difference, and may also be slightly smaller than the standard value of the voltage difference, for example, the preset self-discharge voltage drop is equal to 4.8 mV.

The self-discharge screening method for lithium-ion batteries provided in the embodiments sets three screenings. In the high-temperature screening, based on the principle of the influence of temperature on chemical reaction rate, a manner of increasing the standing temperature combined with voltage drop judgment is used to screen out the batteries to be tested with chemical self-discharge abnormality and obvious type physical self-discharge abnormality. In the room-temperature screening, a longer period of standing combined with voltage drop judgment is used to screen out batteries to be tested with general type physical self-discharge abnormality. In the physical self-discharge screening, the intrinsic voltage drops of the batteries to be tested in multiple standing processes are determined according to the median values of the self-discharge voltage drops of the remaining batteries to be tested in the multiple standing processes. According to the difference between the total voltage drop of the battery to be tested and the corresponding intrinsic voltage drop in the standing processes, the physical self-discharge voltage drops of the battery to be tested in the multiple standing processes are determined, and then a relationship curve of the physical self-discharge voltage drops and the standing durations is fitted. The slope of the relationship curve is determined as the physical self-discharge rate of the battery to be tested. The predicted maximum value of the physical self-discharge voltage drop is calculated by combining the physical self-discharge rate with the longest factory time. Then, according to a relative relationship between the predicted maximum value and a preset self-discharge voltage drop, batteries to be tested with abnormal physical self-discharge are screened out. Therefore, batch screening of batch lithium-ion batteries are realized, and the screening is based on the principles and the inherent characteristics of physical self-discharge and chemical self-discharge, which has theoretical support and further improves the accuracy of self-discharge screening.

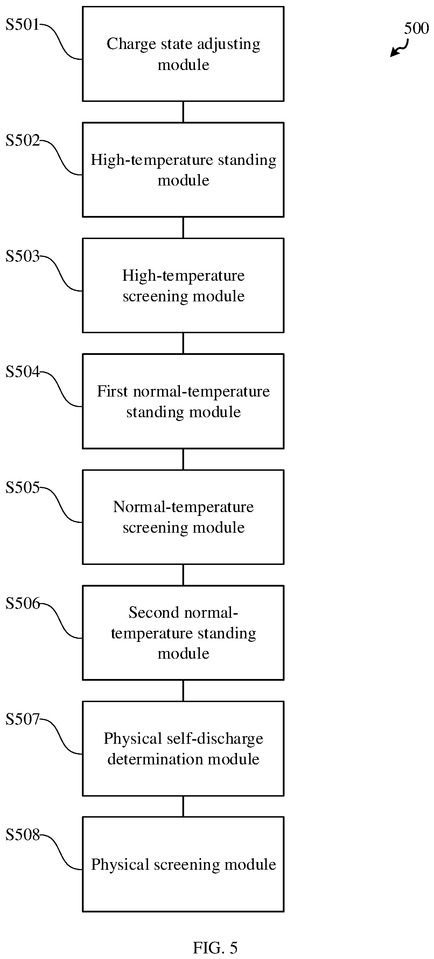

The embodiments of the present disclosure further provide a self-discharge screening apparatus for lithium-ion batteries. FIG. 5 is a schematic structural diagram of a self-discharge screening apparatus for lithium-ion batteries provided by the embodiments of the present disclosure. Referring to FIG. 5, the self-discharge screening apparatus 500 for lithium-ion batteries includes a charge state adjusting module 501, a high-temperature standing module 502, a high-temperature screening module 503, a first room-temperature standing module 504, a room-temperature screening module 505, a second room-temperature standing module 506, a physical self-discharge determination module 507, and a physical screening module 508. The charge state adjusting module 501 is configured to respectively adjust batteries to be tested in a batch to be tested to a preset state of charge. The high-temperature standing module 502 is configured to perform high-temperature standing on the batteries to be tested that are at the preset state of charge. The high-temperature screening module 503 is configured to perform high-temperature screening on the batteries to be tested in the batch to be tested according to state parameters of the batteries to be tested during the high-temperature standing. The first room-temperature standing module 504 is configured to perform first room-temperature standing on remaining batteries to be tested in the batch to be tested after the high-temperature screening. The room-temperature screening module 505 is configured to perform room-temperature screening on the batteries to be tested in the batch to be tested according to state parameters of the batteries to be tested during the high-temperature standing and the first room-temperature standing. The second room-temperature standing module 506 is configured to perform second room-temperature standing on remaining batteries to be tested in the batch to be tested after the room-temperature screening. The physical self-discharge determination module 507 is configured to determine physical self-discharge rates of the batteries to be tested according to state parameters of the batteries to be tested during the high-temperature standing, the first room-temperature standing and the second room-temperature standing. The physical screening module 508 is configured to perform, according to the physical self-discharge rates of the batteries to be tested, physical self-discharge screening on the remaining batteries to be tested in the batch to be tested after the room-temperature screening.

The above-mentioned product can execute the methods provided by any embodiment of the present disclosure, and has corresponding functional modules for executing the methods and beneficial effects.

## Claims

1. A self-discharge screening method for lithium-ion batteries, comprising:
adjusting batteries to be tested in a batch to be tested to a preset state of charge respectively;
performing high-temperature standing on the batteries to be tested that are at the preset state of charge;
performing, according to state parameters of the batteries to be tested during the high-temperature standing, high-temperature screening on the batteries to be tested in the batch to be tested;
performing first room-temperature standing on remaining batteries to be tested in the batch to be tested after the high-temperature screening;
performing, according to state parameters of the batteries to be tested during the high-temperature standing and the first room-temperature standing, room-temperature screening on the remaining batteries to be tested in the batch to be tested;
performing second room-temperature standing on remaining batteries to be tested in the batch to be tested after the room-temperature screening;
determining physical self-discharge rates of the batteries to be tested according to state parameters of the batteries to be tested in the high-temperature standing, the first room-temperature standing and the second room-temperature standing;
performing, according to the physical self-discharge rates of the batteries to be tested, physical self-discharge screening on the remaining batteries to be tested in the batch to be tested after the room-temperature screening.

2. The self-discharge screening method for lithium-ion batteries according to claim 1, wherein the state parameters during the high-temperature standing comprise a first standing duration, first open-circuit voltages of the batteries to be tested before the high-temperature standing, and second open-circuit voltages of the batteries to be tested after the high-temperature standing;
wherein the performing, according to state parameters of the batteries to be tested during the high-temperature standing, high-temperature screening on the batteries to be tested in the batch to be tested, comprises:
calculating first unit voltage drops of the batteries to be tested in the high-temperature standing according to the first standing duration, the first open-circuit voltage, and the second open-circuit voltage;
performing, according to relative relationships between the first unit voltage drops of the batteries to be tested and a first preset voltage drop, high-temperature screening on the batteries to be tested in the batch to be tested.

3. The self-discharge screening method for lithium-ion batteries according to claim 2, wherein the state parameters of the first room-temperature standing comprise a second standing duration and third open-circuit voltages of the batteries to be tested after the first room-temperature standing;
wherein the performing, according to state parameters of the batteries to be tested during the high-temperature standing and the first room-temperature standing, room-temperature screening on the remaining batteries to be tested in the batch to be tested, comprises:
calculating second unit voltage drops of the batteries to be tested in the high-temperature standing and the first room-temperature standing according to the first standing duration, the second standing duration, the first open-circuit voltages and the third open-circuit voltages;
performing, according to relative relationships between the second unit voltage drops of the batteries to be tested and a second preset voltage drop, room-temperature screening on the remaining batteries to be tested in the batch to be tested.

4. The self-discharge screening method for lithium-ion batteries according to claim 1, wherein the determining physical self-discharge rates of the batteries to be tested according to state parameters of the batteries to be tested in the high-temperature standing, the first room-temperature standing and the second room-temperature standing, comprises:
calculating, according to open-circuit voltages before and after multiple standing processes, standing voltage differences generated by the remaining batteries to be tested in the batch to be tested in the standing processes; wherein the standing processes comprise a first process, a second process and a third process, wherein the first process comprises the high-temperature standing; the second process comprises the high-temperature standing and the first room-temperature standing; and the third process comprises the high-temperature standing, the first room-temperature standing and the second room-temperature standing;
determining, according to an average level of the standing voltage differences generated by the remaining batteries to be tested in the batch to be tested in the standing processes, intrinsic voltage drops of the batteries to be tested in the standing processes;
determining, according to a difference between the standing voltage differences of the remaining batteries to be tested in the batch to be tested and a corresponding intrinsic voltage drop, a physical self-discharge voltage drop of the batteries to be tested in the multiple standing processes;
determining physical self-discharge rates of the batteries to be tested according to the physical self-discharge voltage drops of the batteries to be tested and the standing durations in the multiple standing processes.

5. The self-discharge screening method for lithium-ion batteries according to claim 4, wherein the determining, according to an average level of the standing voltage differences generated by the remaining batteries to be tested in the batch to be tested in the standing processes, intrinsic voltage drops of the batteries to be tested in the standing processes, comprising:
ranking the standing voltage differences generated by the plurality of batteries to be tested in the standing processes in order of the values of the standing voltage differences;
determining, according to the ranking of the standing voltage differences, a median value of the standing voltage differences as the intrinsic voltage drop of the batteries to be tested in the standing processes.

6. The self-discharge screening method for lithium-ion batteries according to claim 4, wherein the determining physical self-discharge rates of the batteries to be tested according to the physical self-discharge voltage drops of the batteries to be tested and the standing durations in the multiple standing processes, comprises:
fitting, according to the physical self-discharge voltage drops of the batteries to be tested in the multiple standing processes and the standing durations, a relationship curve of the physical self-discharge voltage drops of the batteries to be tested and the standing durations;
determining the physical self-discharge rate of the batteries to be tested according to the slope of the relationship curve.

7. The self-discharge screening method for lithium-ion batteries according to claim 1, wherein the performing, according to the physical self-discharge rates of the batteries to be tested, physical self-discharge screening on the remaining batteries to be tested in the batch to be tested after the room-temperature screening, comprising:
determining, according to a longest factory time and the physical self-discharge rates of the batteries to be tested, predicted maximum values of the physical self discharge voltage drops of the batteries to be tested before a first use of the batteries;
performing, according to a relative relationship between the predicted maximum value of the battery to be tested and a preset self-discharge voltage drop, physical self-discharge screening on the remaining batteries to be tested in the batch to be tested after the room-temperature screening.

8. The self-discharge screening method for lithium-ion batteries according to any one of claims 1 to 7, wherein a standing temperature of the high-temperature standing is between 40°C and 50°C; standing temperatures of the first room-temperature standing and the second room-temperature standing are both between 20°C and 30°C.

9. The self-discharge screening method for lithium-ion batteries according to any one of claims 1 to 7, wherein a standing duration of the high-temperature standing is between 2 days to 3 days; a standing duration of the first room-temperature standing is between 2 days to 4 days; a standing duration of the second room-temperature standing is between 3 days to 5 days.

10. A self-discharge screening apparatus for lithium-ion batteries, comprising:
a charge state adjusting module configured to respectively adjust batteries to be tested in a batch to be tested to a preset state of charge;
a high-temperature standing module configured to perform high-temperature standing on the batteries to be tested;
a high-temperature screening module configured to perform high-temperature screening on the batteries to be tested in the batch to be tested according to state parameters of the batteries to be tested during the high-temperature standing;
a first room-temperature standing module configured to perform first room-temperature standing on remaining batteries to be tested in the batch to be tested after the high-temperature screening;
a room-temperature screening module configured to perform, according to state parameters of the batteries to be tested during the high-temperature standing and the first room-temperature standing, room-temperature screening on the remaining batteries to be tested in the batch to be tested that are at the preset state of charge;
a second room-temperature standing module configured to perform second room-temperature standing on remaining batteries to be tested in the batch to be tested after the room-temperature screening;
a physical self-discharge determination module configured to determine physical self-discharge rates of the batteries to be tested according to state parameters of the batteries to be tested during the high-temperature standing, the first room-temperature standing and the second room-temperature standing;
a physical screening module configured to perform, according to the physical self-discharge rates of the batteries to be tested, physical self-discharge screening on the remaining batteries to be tested in the batch to be tested after the room-temperature screening.
